# EUROPEAN PATENT SPECIFICATION

(11) **EP 3 913 596 B1**
(45) Date of publication and mention of the grant of the patent: **01.11.2023**
(21) Application number: 20215271.6
(22) Date of filing: 18.12.2020
(51) Int. Cl.: G05B 17/02, G08G 1/00, G08G 1/16

(54) **METHOD FOR CONTROLLING SIMULATION VEHICLE AND ELECTRONIC DEVICE**
VERFAHREN ZUR STEUERUNG EINES SIMULATIONSFAHRZEUGS UND ELEKTRONISCHE VORRICHTUNG
PROCÉDÉ DE COMMANDE DE VÉHICULE DE SIMULATION ET DISPOSITIF ÉLECTRONIQUE

(30) Priority: 20.05.2020 CN 202010431980
(43) Date of publication of application: 24.11.2021
(73) Proprietor: Apollo Intelligent Driving Technology (Beijing) Co., Ltd., Haidian District Beijing 100085 (CN)
(72) Inventor: ZHOU, Jie, Beijing, 100085 (CN); ZHAO, Ming, Beijing, 100085 (CN); ZHANG, Liancheng, Beijing, 100085 (CN); LI, Hao, Beijing, 100085 (CN); WU, Hang, Beijing, 100085 (CN); GUO, Qiang, Beijing, 100085 (CN); ZHOU, Sunjie, Beijing, 100085 (CN); DONG, Fangfang, Beijing, 100085 (CN); MAO, Jiming, Beijing, 100085 (CN); LI, Bo, Beijing, 100085 (CN)
(74) Representative: Zimmermann, Tankred Klaus

(56) References cited:
- US-A1- 2018 322 230
- US-A1- 2019 389 474

## Description

### FIELD

Embodiments of the present disclosure generally relate to a field of automatic driving, and more particularly to a method for controlling a simulation vehicle.

### BACKGROUND

In a field of automatic driving, relying on a real-vehicle test to verify effect of an algorithm is a high-cost and low-efficiency way. Verification and iteration of the algorithm may be sped up by simulating a traffic environment in the real world to run a vehicle. Presently, the simulation is generally based on a fixed scene model with a short distance. The vehicle generally runs for tens of seconds, which lacks stability and reliability verification under a long period running. In addition, there is only one vehicle in the simulation, and the others are all obstacles, thus lacking a verification ability for interaction and overtaking among multiple vehicles.

US 2019/389474 A1 discloses a method for controlling an unmanned vehicle during a performance test, wherein the vehicle is controlled according to environment information, including obstacles.

### SUMMARY

The invention provides a method for controlling a simulation vehicle according to claim 1 and the preferable features according to the invention are defined in the dependent claims.

According to the solution of the invention, problems of low calculation efficiency and resources idleness caused by the need to wait for all the vehicles to complete the calculation and synchronize calculation results before performing the simulation of the next moment are solved , improving the calculation efficiency and avoids the resources idleness.

It should be understood that, the present disclosure does not aim to limit a key or important feature in embodiments of the present disclosure, and does not used to limit the scope of the invention, which is defined by the appended claims. Other features of the present disclosure will be easily understood by following descriptions.

### BRIEF DESCRIPTION OF THE DRAWINGS

The above and other features, advantages and aspects of respective embodiments of the present disclosure will become more apparent with reference to accompanying drawings and following detailed illustrations. In the accompanying drawings, the same or similar numeral references represent the same or similar elements, in which:
FIG. 1 is a schematic diagram illustrating an environment 100 for processing information according to embodiments of the present disclosure;
FIG. 2 is a flow chart illustrating a method 200 for controlling a simulation vehicle according to embodiments of the present disclosure;
FIG. 3 is a flow chart illustrating a method 300 for controlling a simulation vehicle according to embodiments of the present disclosure;
FIG. 4 is a schematic diagram illustrating a divided region 400 according to embodiments of the present disclosure;
FIG. 5 is a block diagram illustrating an apparatus 500 for controlling a simulation vehicle according to embodiments of the present disclosure;
FIG. 6 is a block diagram illustrating an apparatus 600 for controlling a simulation vehicle according to embodiments of the present disclosure; and
FIG. 7 is a block diagram illustrating an electronic device capable of implementing a method for controlling a simulation vehicle of embodiments of the present disclosure.

### DETAILED DESCRIPTION

Description will be made below to exemplary embodiments of the present disclosure with reference to accompanying drawings, which includes various details of embodiments of the present disclosure to facilitate understanding, and should be regarded as merely examples. Therefore, it should be recognized by the skilled in the art that various changes and modifications may be made to the embodiments described herein without departing from the scope of the present disclosure. Meanwhile, for clarity and conciseness, descriptions for well-known functions and structures are omitted in the following description.

As used herein, the term "include" and its equivalents should be understood as an open "include", that is, "include but not limited to". Unless specifically stated, the term "or" should be understood as "and/or". The term "based on" should be understood as "based at least in part (at least partially based on)". The term "an exemplary embodiment" and "an embodiment" should be understood as "at least one exemplary embodiment". The term "another exemplary embodiment" should be understood as "at least another embodiment". The terms "first", "second" and the like should be understood as different or the same objects. The term "vehicle" may include a simulation vehicle simulated by a simulation system. Other explicit and implicit definitions may be included below.

As mentioned above, presently, simulation is generally based on a fixed scene model with a short distance, and a vehicle generally runs for tens of seconds, which lacks stability and reliability verification under a long period running. In addition, there is only one vehicle in the simulation, and others are all obstacles, thus lacking a verification ability for interaction and overtaking among multiple vehicles. In order to support a long-period simulation of multiple vehicles, distributed architecture is generally employed for parallel calculation to meet a computational efficiency requirement. Presently, due to a possible overtaking and coupling relationship among multiple vehicles, at each simulation time point, it is necessary to wait for all vehicles completing the calculation and synchronizing calculation results before performing a simulation at a next time point. Therefore, the simulation efficiency is inevitably limited by a vehicle with a slow calculation speed, thereby causing serious resource idleness.

To at least partially solve one or more of the above problems and other potential problems, exemplary embodiments of the present disclosure provide a method for controlling a simulation vehicle. In this method, a first region corresponding to a first simulation position where the simulation vehicle is located at a first time point is determined, first environment information about the first region and second environment information about a second region adjacent to the first region are obtained, the first environment information and the second environment information are sent to a control device of the simulation vehicle, and a first action performed by the simulation vehicle at a second time point after the first time point is determined based on a control signal in response to receiving the control signal from the control device. The control signal is determined by the control device based on the first environment information and the second environment information.

In this way, by obtaining the environment information related to the region where the simulation vehicle position is located and the environment information of regions adjacent to the region where the simulation vehicle position is located for vehicle control decision-making, the vehicle control decision-making is simply based on the limited regions around the simulation vehicle, and in a vehicle simulation procedure, there is no need to wait for control results of simulation vehicles in regions other than the limited regions around the simulation vehicle, thereby improving the calculation efficiency and avoiding the idle resources.

Detailed examples of this solution will be described more clearly below with reference to accompanying drawings.

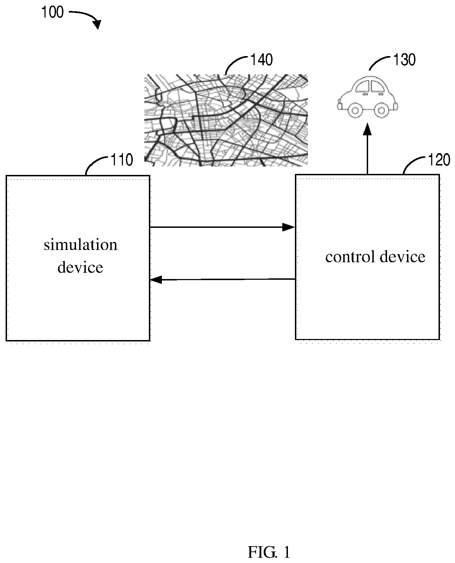

FIG. 1 is a schematic diagram illustrating an environment 100 for information processing according to embodiments of the present disclosure. The environment 100 may include a simulation device 110 and a control device 120 of a simulation vehicle 130.

The simulation device 110 may be configured to run a simulation system 140 for the simulation vehicle's driving. One or more simulation vehicles 130 controlled by one or more control devices 120 may run in the simulation system 140. The simulation system 140 may include a static environment and a dynamic environment. The static environment includes, but is not limited to, road network information. The dynamic environment includes, but is not limited to, traffic flow, also referred as obstacles. The simulation device 110 may maintain a virtual clock. The simulation device 110 may send environment information at any virtual time point to the control device 120 of the simulation vehicle 130, receive a control signal for the simulation vehicle 130 from the control device 120, and determine an action performed by the simulation vehicle 130 at a next virtual time point based on the control signal. In addition, the simulation device 110 may determine an action performed by an obstacle at the next virtual time point based on a model corresponding to the obstacle and environmental information at any virtual time point. In some embodiments, the simulation system may be divided into multiple regions, such as multiple map grids. The simulation vehicle 130 may be classified into a corresponding region based on a position of the simulation vehicle 130.

The simulation device 110 includes, but is not limited to, a server computer, a multiprocessor system, a mainframe computer, and a distributed computing environment including any of the above systems or devices. In some embodiments, the simulation device 110 may include one or more processing units, including a specific processing unit such as a graph processing unit (GPU), a field programmable gate array (FPGA) and an application specific integrated circuit (ASIC), and a general processing unit such as a central processing unit (CPU). In some embodiments, the simulation device 110 may include a server cluster including a control server and multiple work servers. For example, the calculation of the simulation vehicle 130 and the obstacle located in a region may be completed by one work server, and multiple work servers may perform calculation in parallel, such that the calculation of multiple regions may be performed in parallel.

The control device 120 may run a program for controlling the simulation vehicle 130, such as, but is not limited to an automatic driving program. The control device 120 may receive environment information from the simulation device 110, determine a control signal for the simulation vehicle 130 based on the environment information, and send the control signal to the simulation device 110. There may be one or more control devices 120. The control device 120 may control one or more simulation vehicles 130. For example, the control device 120 includes, but is not limited to, a personal computer, a server computer, a multiprocessor system, a mainframe computer, and a distributed computing environment including any of the above systems or devices.

The simulation device 110 is configured to determine a first region corresponding to a first simulation position where the simulation vehicle 130 is located at a first time point, to obtain first environment information about the first region and second environment information about a second region adjacent to the first region, to send the first environment information and the second environment information to the control device 120 of the simulation vehicle 130, and to determine a first action performed by the simulation vehicle 130 at a second time point after the first time point based on a control signal in response to receiving the control signal from the control device 120. The control signal is determined by the control device based on the first environment information and the second environment information.

The control device 120 is configured to receive the first environment information about the first region and the second environment information about the second region adjacent to the first region from the simulation device 110. The first region corresponds to the first simulation position where the simulation vehicle 130 is located at the first time point. The control device 120 is further configured to generate the control signal for the simulation vehicle 130 based on the first environment information and the second environment information, and to send the control signal to the simulation device 110. The control signal causes the simulation vehicle 130 to perform the first action at the second time point after the first time point.

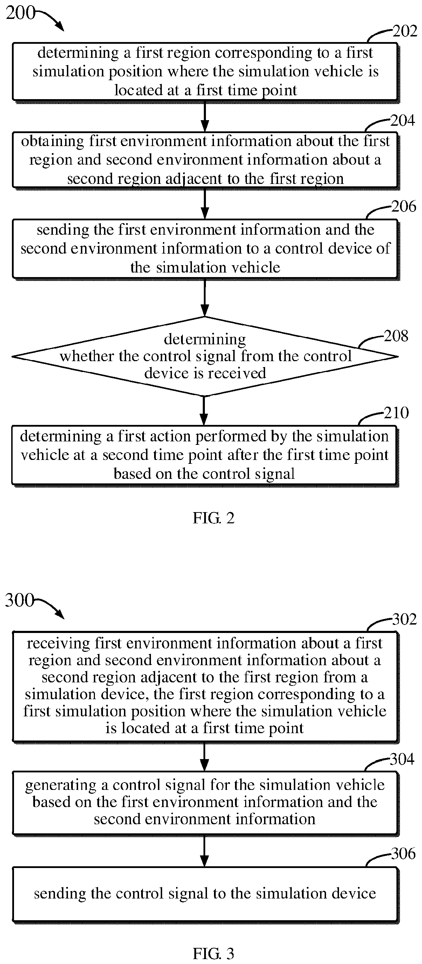

FIG. 2 is a flow chart illustrating a method 200 for controlling a simulation vehicle 130 according to embodiments of the present disclosure. For example, the method 200 may be implemented by the simulation device 110 illustrated in FIG. 1. It should be understood that, the method 200 may include additional blocks not illustrated and/or may omit blocks illustrated. The scope of the present disclosure is not limited thereto.

At block 202, the simulation device 110 determines a first region corresponding to a first simulation position where the simulation vehicle 130 is located at a first time point. The simulation system may be divided into at least one region, and each region may correspond to a certain simulation location range. If the first simulation position where the simulation vehicle 130 is located at the first time point is within a simulation position range corresponding to a certain region, the first simulation position corresponds to the certain region. The region may have a regular shape, such as a square, a rectangle, or may have an irregular shape.

In some embodiments, the first region may be determined in multiple ways. For example, the simulation device 110 may obtain predetermined correspondence information between simulation positions and regions, and then determine the first region corresponding to the first simulation position based on the predetermined corresponding information. The predetermined correspondence information includes, but is not limited to, a predetermined correspondence table. Taking a square region as an example, a simulation position range corresponds to a region A with abscissa from 0 to 10 and ordinate from 0 to 10, a simulation position range corresponds to a region B with abscissa from 10 to 20 and ordinate from 0 to 10, and a simulation position range corresponds a region C with abscissa from 20 to 30 and ordinate from 0 to 10. The predetermined correspondence information may be illustrated as Table 1 below.

**Table 1**

| regions | position ranges |
|---|---|
| A | 0<x<10,0<y<10 |
| B | 10<x<20,0<y<10 |
| C | 20<x<30,0<y<10 |

For example, if the simulation position where the simulation vehicle 130 located at the first time point is (15, 5), the simulation position corresponds to the region B. With the predetermined correspondence information between the simulation positions and the regions, a region may be conveniently determined based on the simulation position.

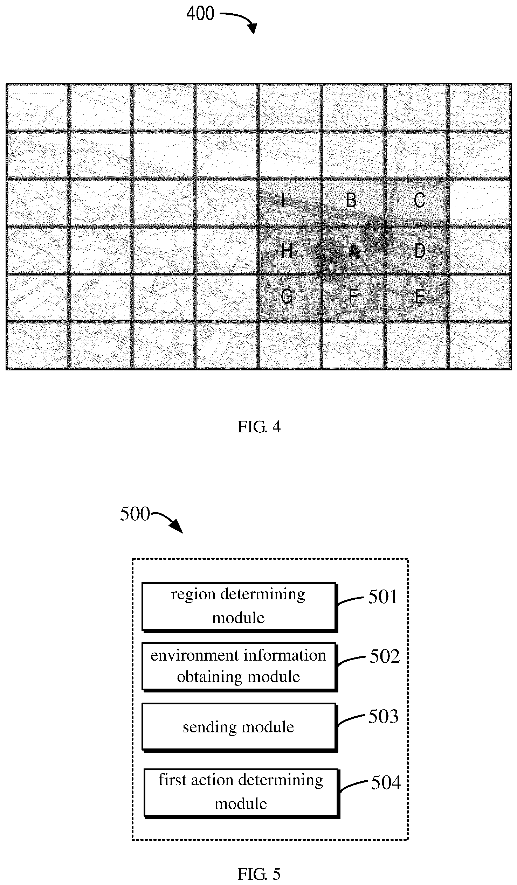

At block 204, the simulation device 110 obtains first environment information about the first region and second environment information about a second region adjacent to the first region. The second region adjacent to the first region may include a region having an edge adjacent to the first region and/or a region having a point adjacent to the first region. Referring to FIG. 4, for example, the region A is the first region, the second region adjacent to the region A includes regions B, D, F and H having edges adjacent to the region A and regions C, E, G and I having points adjacent to the region A. It should be understood that, the second region including these nine regions is only an example. When the first region is located at the boundary of the simulation system, the second region adjacent to the first region may include three or five regions. In addition, when the simulation system or the first region is irregular, the second region may have fewer or more regions adjacent to the first region.

In some embodiments, the simulation device 110 may obtain at least one of first obstacle information and first road network information related to the first region, and obtain at least one of second obstacle information and second road network information related to the second region. The obstacle includes, but is not limited to, a traffic object in the simulation system, such as a motor vehicle, a non-motor vehicle, and a pedestrian. The first obstacle information includes, but is not limited to, simulation sensor data about an obstacle in the first region, such as lidar data or millimeter wave radar data. The first road network information includes, but is not limited to, road information, fixed object information around the road, and/or other possible information. The road information includes, such as, a position, a category, a width, a slope and a curvature of a lane line. The fixed object information around the road includes, such as, a traffic sign, and a traffic light. The second obstacle information and the second road information are respectively similar to the first obstacle information and the first road network information, which are not described again. By obtaining the obstacle information and the road network information, the vehicle control decision-making may be performed based on static environment and dynamic environment, and a vehicle decision basis is closer to a real condition.

In some embodiments, the simulation device 110 may obtain perceptual information about the obstacle in the first region. The perceptual information may indicate at least one of a position, a shape, a category, a speed and an orientation of the obstacle and/or other possible information. The position of the obstacle may be coordinates of the obstacle. The shape of the obstacle may include a length, a width and a height of the obstacle. The category of the obstacle may include a motor vehicle, a non-motor vehicle and a pedestrian. The orientation of the obstacle may include a direction along a driving direction of the vehicle, a direction opposite to the driving direction of the vehicle or other suitable direction. By obtaining the perception information of the obstacle, a decision planning ability of the control device 120 may be simply and accurately tested.

At block 206, the simulation device 110 may send the first environment information and the second environment information to the control device 120 of the simulation vehicle 110. After receiving the first environment information and the second environment information, the control device 120 may take the first environment information and the second environment information as an input of the vehicle control decision-making and generate a control signal for the simulation vehicle 130. The control signal is configured to control an action performed by the simulation vehicle 130, such as, turning, accelerating, decelerating, moving on, moving back, and braking. For example, when the first environment information and the second environment information indicate that there is an obstacle in front of the simulation vehicle 130, the control device 120 may generate a turning signal for the simulation vehicle 130. When the first environment information and the second environment information indicate that there is no obstacle in front of the simulation vehicle 130, the control device 120 may generate a moving-on or accelerating signal for the simulation vehicle 130. After the control signal is generated, the control device 120 may send the control signal to the simulation device 110 through a communication module.

At block 208, the simulation device 110 determines whether the control signal for the simulation vehicle 130 is received from the control device 120. The control signal is determined by the control device 120 based on the first environment information and the second environment information.

When the simulation device 110 receives the control signal for the simulation vehicle 130 from the control device 120 at block 208, a first action performed by the simulation vehicle 130 at a second time point after the first time point is determined based on the control signal at block 210. The first action may be used to determine a position of the simulation vehicle 130 at the second time point.

In some embodiments, the simulation device 110 may determine the first action performed by the simulation vehicle 130 at the second time point based on the control signal and a predetermined vehicle dynamic model. The first action may include braking, turning, moving on, moving back, accelerating and decelerating and/ or other possible actions. Turning may include turning left, turning right, turning around, etc. Accelerating may include increasing to a target speed or increasing by a speed difference. Decelerating may include reducing to a speed or reducing by a speed difference. With the vehicle dynamic model, the action performed by the simulation vehicle may simulate the real action more accurately, improving the simulation confidence.

In this way, the environment information related to the region where the simulation vehicle is located and the environment information of adjacent regions are obtained for the vehicle control decision-making, such that the vehicle control decision-making is simply based on the limited regions around the simulation vehicle, and there is no need to wait for control results of simulation vehicles in regions other than the limited regions around the simulation vehicle in the vehicle simulation procedure, thereby improving the calculation efficiency and avoiding the idle resources.

In some embodiments, the simulation device 110 may also obtain a simulation model corresponding to the obstacle in the first region. Then, the simulation device 110 may determine a second action performed by the obstacle at the second time point based on the simulation model, the first environment information and the second environment information. Different types of obstacles may correspond to different simulation models, such as a motor vehicle model, a non-motor vehicle model, and a pedestrian model, thus the simulation obstacle is closer to a real obstacle, thereby improving the confidence of the simulation result. In addition, based on the environment information related to the region where the obstacle is located and the adjacent regions, a basis of action decision of the obstacle is simply based on local environment information, which improves the calculation efficiency of the simulation.

Alternatively or additionally, in some embodiments, the simulation device 110 may also determine whether the first action performed by the simulation vehicle 130 at the second time point meets a predetermined evaluation criterion related to vehicle driving. The simulation device 110 stores scene information associated with the second time point and the simulation vehicle 130 in response to determining that the first action does not meet the predetermined evaluation criterion. The predetermined evaluation criterion may include evaluation criterions related to a driving reasonability, such as collision, running over a line, running a red light, and overwhelm. Therefore, the simulation device may automatically evaluate the driving action of the simulation vehicle 130, and automatically store the associated scene information that does not meet the predetermined evaluation criterion, thus beneficial to store high-value scenes for playback or debugging.

Alternatively or additionally, in some embodiments, the simulation device 110 may also determine whether a scene information storing request is received from the control device 120, and store scene information associated with the second time point and the simulation vehicle 130 in response to receiving the scene information storing request from the control device 120. In this way, the simulation device may store related scene information based on the scene information storing request from the control device. The control device 120 may store the scene information more accurately because it may accurately represent an internal state of the simulation vehicle 130.

In some embodiments, the simulation device 110 may store at least one of event information, environment information, communication information, log information or other information associated with the second time point and the simulation vehicle 130. The event information may refers to an event triggered by the action performed by the simulation vehicle 130 at the second time point. For example, the simulation vehicle 130 collides with an obstacle, or the simulation vehicle 130 runs a red light. The environment information refers to, such as, environment information related to the region corresponding to the position where the simulation vehicle 130 is located at the second time point and environment information related to the regions adjacent to the region corresponding to the position where the simulation vehicle 130 is located at the second time point. For example, the environment information may include obstacle information, and road network information, etc. The communication information may include communication data between the simulation device 110 and the control device 120, such as the first environment information, the second environment information and the control signal. The log information may be, such as, a record of a system-related status or information. It should be understood that, the above information is only exemplary and not restrictive, and the simulation device 110 may store any suitable information associated with the second time point and the simulation vehicle 130. In this way, by storing one or more types of scene information associated with the simulation vehicle 130 and a required time point, problems may be found more conveniently and quickly in the subsequent playback or debugging procedure.

Alternatively or additionally, in some embodiments, the simulation device 110 may also determine whether communication between the simulation device 110 and the control device 120 is abnormal. The simulation vehicle 130 is restarted in response to determining that the communication between the simulation device 110 and the control device 120 is abnormal. Communication abnormality may include, but be not limited to, failing to receive the control signal from the control device 120 within a predetermined time interval. In this way, the simulation vehicle 130 may be restarted without ending the simulation in case of the communication abnormality caused by collapse of the control device 120 or by a communication link problem, improving the fault tolerance of the simulation system and ensuring that the simulation vehicle 130 may run for a long period to accumulate simulation data.

Alternatively or additionally, in some embodiments, the simulation device 110 may also convert a loaded map into a topological graph, and divide the topological graph into multiple regions. The loaded map includes, but is not limited to, a high-precision map. The true confidence of the simulation system may be improved by employing the high-precision map. By converting the loaded map into the topological graph, it may be suitable for driving the obstacle in the simulation, and by dividing the topological graph into multiple regions, it may be convenient for regionalized parallel calculation and the vehicle decision-making based on the region corresponding to the position where the simulation vehicle 130 is located.

FIG. 3 is a flow chart illustrating a method 300 for controlling a simulation vehicle 130 according to embodiments of the present disclosure. For example, the method 300 may be performed by the control device 120 of the simulation vehicle 130 as illustrated in FIG. 1. It should be understood that, the method 300 may also include additional blocks not illustrated and/or omit the illustrated blocks, and the scope of the present disclosure is not limited thereto.

At block 302, the control device 120 receives first environment information about a first region and second environment information about a second region adjacent to the first region from the simulation device 110. The first region corresponds to a first simulation position where the simulation vehicle 130 is located at a first time point.

In some embodiments, the control device 120 may receive at least one of first obstacle information and first road network information related to the first region, and at least one of second obstacle information and second road network information related to the second region from the simulation device 110. Examples of the obstacle information and the road network information here may be referred to the above embodiments, which may not be elaborated here. By obtaining the obstacle information and the road network information, vehicle control decision-making may be performed based on static environment and dynamic environment, and the vehicle decision basis is closer to the real situation.

In some embodiments, the control device 120 may receive perceptual information about an obstacle in the first region from the simulation device 110. The perceptual information may indicate a position, a shape, a category, a speed and an orientation of the obstacle and /or other possible information. Examples of such information may be referred to the above embodiments, which is not elaborated here. By receiving the perception information of the obstacle, the decision planning ability of the control device 120 may be simply and accurately tested.

At block 304, the control device 120 generates a control signal for the simulation vehicle 130 based on the first environment information and the second environment information. The control signal causes the simulation vehicle 130 to perform a first action at a second time point after the first time point.

At block 306, the control device 120 sends the control signal to the simulation device 110.

In this way, by receiving the environment information related to the region where the simulation vehicle is located and the environment information related to the adjacent regions for the vehicle control decision-making, the vehicle control decision-making is simply based on the limited regions around the simulation vehicle, and in the vehicle simulation procedure, there is no need to wait for the control results of simulation vehicles in regions other than the limited regions around the simulation vehicle, thereby improving the calculation efficiency and avoiding the idle resources.

FIG. 5 is a block diagram illustrating an apparatus 500 for controlling a simulation vehicle 130 according to embodiments of the present disclosure. As illustrated in FIG. 5, the apparatus 500 includes a region determining module 501, an environment information obtaining module 502, a sending module 503, and a first action determining module 504. The region determining module 501 is configured to determine a first region corresponding to a first simulation position where the simulation vehicle 130 is located at a first time point. The environment information obtaining module 502 is configured to obtain first environment information about the first region and second environment information about a second region adjacent to the first region. The sending module 530 is configured to send the first environment information and the second environment information to a control device 120 of the simulation vehicle 130. The first action determining module 504 is configured to determine a first action performed by the simulation vehicle 130 at a second time point after the first time point based on a control signal in response to receiving the control signal from the control device 120, the control signal being determined by the control device 120 based on the first environment information and the second environment information.

In some embodiments, the region determining module 501 includes: a correspondence information obtaining submodule and a region determining submodule. The correspondence information obtaining submodule is configured to obtain predetermined correspondence information between simulation positions and regions. The region determining submodule is configured to determine the first region corresponding to the first simulation position based on the predetermined correspondence information.

In some embodiments, the environment information obtaining module 502 includes: a first environment obtaining submodule and a second environment obtaining submodule. The first environment obtaining submodule is configured to obtain at least one of first obstacle information and first road network information related to the first region. The second environment obtaining submodule is configured to obtain at least one of second obstacle information and second road network information related to the second region.

In some embodiments, the first environment obtaining submodule includes: a perceptual information obtaining unit. The perceptual information obtaining unit is configured to obtain perceptual information about an obstacle in the first region. The perceptual information indicates at least one of a position, a shape, a category, a speed and an orientation of the obstacle.

In some embodiments, the first action determining module 504 includes: a vehicle action determining submodule. The vehicle action determining submodule is configured to determine the first action based on the control signal and a predetermined vehicle dynamic model. The first action includes at least one of braking, turning, moving on, moving back, accelerating and decelerating.

In some embodiments, the apparatus 500 also includes: a simulation model obtaining module and a second action determining module. The simulation model obtaining module is configured to obtain a simulation model corresponding to an obstacle in the first region. The second action determining module is configured to determine a second action performed by the obstacle at the second time point based on the simulation model, the first environment information and the second environment information.

In some embodiments, the apparatus 500 also includes: an action evaluation module and a scene storing module. The action evaluation module is configured to determine whether the first action meets a predetermined evaluation criterion related to vehicle driving. The scene storing module is configured to store scene information associated with the second time point and the simulation vehicle 130 in response to determining that the first action does not meet the predetermined evaluation criterion.

Alternatively or additionally, in some embodiments, the apparatus 500 also includes: a scene storing module. The scene storing module is configured to store scene information associated with the second time point and the simulation vehicle 130 in response to receiving a scene information storing request from the control device.

In some embodiments, the scene storing module includes: a scene information storing submodule. The scene information storing submodule is configured to save at least one of event information, environment information, communication information and log information associated with the second time point and the simulation vehicle.

In some embodiments, the apparatus 500 also includes a restarting module. The restarting module is configured to restart the simulation vehicle 130 in response to determining that communication between a simulation device and the control device is abnormal.

In some embodiments, the apparatus 500 also includes a map converting module and a region dividing module. The map converting module is configured to convert a loaded map into a topological graph. The region dividing module is configured to divide the topological graph into a plurality of regions.

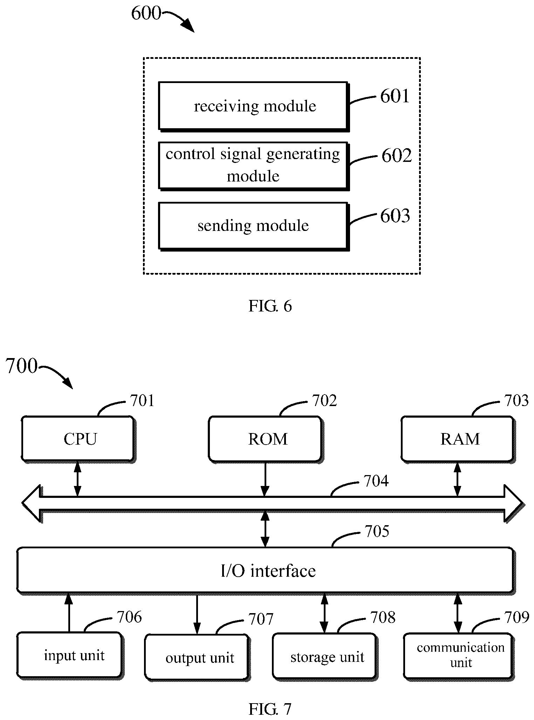

FIG. 6 is a block diagram illustrating an apparatus 600 for controlling a simulation vehicle 130 according to embodiments of the present disclosure. As illustrated in FIG. 6, the apparatus 600 includes: a receiving module 601, a control signal generating module 602 and a sending module 603. The receiving module 601 is configured to receive first environment information about a first region and second environment information about a second region adjacent to the first region from a simulation device 110. The first region corresponds to a first simulation position where the simulation vehicle is located at a first time point. The control signal generating module 602 is configured to generate a control signal for the simulation vehicle 130 based on the first environment information and the second environment information. The control signal causes the simulation vehicle 130 to perform a first action at a second time point after the first time point. The sending module 630 is configured to send the control signal to the simulation device 110.

In some embodiments, the receiving module 601 includes: an environment information receiving submodule. The environment information receiving submodule is configured to receive at least one of first obstacle information and first road network information related to the first region, and at least one of second obstacle information and second road network information related to the second region from the simulation device.

In some embodiments, the environment information receiving submodule includes: a perceptual information receiving unit. The perceptual information receiving unit is configured to receive perceptual information about an obstacle in the first region from the simulation device. The perceptual information indicates at least one of a position, a shape, a category, a speed and an orientation of the obstacle.

FIG. 7 is a block diagram illustrating an exemplary device 700 capable of implementing embodiments of the present disclosure. For example, the simulation device 110 and the control device 120 illustrated in FIG. 1 may be implemented by the device 700. As illustrated in FIG. 7, the device 700 includes a central processing unit (CPU) 701, which may execute various appropriate acts and processing based on computer program instructions stored in a read-only memory (ROM) 702 or computer program instructions loaded from a storage unit 708 to a random-access memory (RAM) 703. In the RAM 703, various programs and data needed for the operation of the device 700 may be stored. The CPU 701, the ROM 702, and the RAM 703 are connected to each other through a bus 704. An input/output (I/O) interface 705 is also connected to the bus 704.

Multiple components in the device 700 are connected to the I/O interface 705, including: an input unit 706, such as a keyboard, a mouse, or a microphone.; an output unit 707, such as various types of displays, speakers, etc.; the storage unit 708, such as a disk, a CD, etc.; and a communication unit 709, such as a network card, a modem, a wireless communication transceiver, etc.. The communication unit 709 allows the device 700 to exchange information/data with other devices via computer networks such as the Internet and/or various telecommunications networks.

The processing unit 701 executes the various methods and procedures described above, such as the methods 200-300. For example, in some embodiments, the methods 200-300 may be implemented as computer software programs, which are physically contained in a machine readable medium, such as the storage unit 708. In some embodiments, some or all of the computer programs may be loaded and/or installed on the device 700 via the ROM 702 and/or the communication unit 709. The computer programs may execute one or more acts or steps of the methods 200-300 described above when loaded to the RAM 703 and executed by the CPU 701.

The present disclosure may be a method, apparatus, system and/or computer program product. The computer program product may include a computer readable storage medium having computer readable program instructions stored thereon for performing various aspects of the present disclosure.

The computer readable storage medium may be a tangible device that may hold and store instructions used by an instruction execution device. The computer readable storage medium may be, but not limited to, an electrical storage device, a magnetic storage device, an optical storage device, an electromagnetic storage device, a semiconductor storage device, or any suitable combination thereof. More specific examples (non-exhaustive list) of the computer readable storage medium include: a portable computer disk, a hard disk, a random access memory (RAM), a read-only memory (ROM), an erasable programmable read-only memory (EPROM or flash memory), a static random access memory (SRAM), a portable compact disk read-only memory (CD-ROM), a digital versatile disk (DVD), a memory stick, a floppy disk, a mechanical coding device having punch cards storing instructions or a raised structure in a groove, and any combination thereof. As used herein, the computer readable storage medium is not interpreted as an instantaneous signal itself, which may be such as radio waves or other freely propagating electromagnetic waves, electromagnetic waves propagated through waveguides or other transmission media (such as, optical pulses through fiber optic cables), or electrical signals transmitted through wires.

The computer readable program instructions described herein may be downloaded from the computer readable storage medium to various computing/processing devices, or downloaded to an external computer or an external storage device via a network, such as the Internet, a local area network, a wide area network, and/or a wireless network. The network may include copper transmission cables, optical fiber transmission, wireless transmission, routers, firewalls, switches, gateway computers and/or edge servers. The network adapter card or network interface in each computing/processing device receives the computer readable program instructions from the network and forwards the computer readable program instructions for storing in the computer readable storage medium in each computing/processing device.

Computer program instructions for performing operations of the present disclosure may refer to assembly instructions, instruction set architecture (ISA) instructions, machine instructions, machine-related instructions, microcode, firmware instructions, state setting data, or source code or object code written in any combination of one or more programming languages. The program languages include object-oriented programming languages, such as Java, Smalltalk, C++, further include conventional procedural programming languages, such as the C programming language or similar programming languages. The computer readable program instructions may execute entirely on the computer of the user, partly on the computer of the user, as a stand-alone software package, partly on the computer of the user and partly on a remote computer, or entirely on the remote computer or server. In the latter scenario, the remote computer may be connected to the user's computer through any type of network, including a local area network (LAN) or a wide area network (WAN), or the connection may be made to an external computer (for example, through the Internet using an Internet service provider). In some embodiments, electronic circuits, such as programmable logic circuits, field programmable gate arrays (FPGA), or programmable logic arrays (PLA), may be customized by utilizing state information of the computer readable program instructions, thereby implementing various aspects of the present disclosure.

Various aspects of the present disclosure are described herein with reference to flow charts and/or block diagrams of methods, devices (systems) and computer program products based on embodiments of the present disclosure. It should be understood that each block of the flow chart and/or the block diagram and a combination of blocks in the flow chart and/or the block diagram may be implemented by the computer readable program instructions.

These computer readable program instructions may be provided to a processing unit of a general-purpose computer, a special-purpose computer or other programmable data processing apparatus, thereby producing a machine, such that these instructions, when executed by the processing unit of the computer or other programmable data processing apparatus, produce means for implementing the functions/actions specified in one or more blocks in the flow chart and/or the block diagram. These computer readable program instructions may also be stored in the computer readable storage medium. These instructions cause the computer, the programmable data processing device, and/or other devices to operate in a specific manner. Thus, the computer readable medium storing these instructions includes a manufacture, which includes instructions to implement various aspects of the functions/actions specified in one or more blocks in the flow chart and/or the block diagram.

The computer readable program instructions may also be loaded to a computer, other programmable data processing apparatus, or other device, such that a series of operational steps may be executed on the computer, other programmable data processing apparatus, or other device to produce a computer-implemented procedure. Thus, the instructions executed on the computer, other programmable data processing apparatus, or other device are configured to implement the functions/actions specified in one or more blocks in the flow chart and/or the block diagram.

The flow charts and the block diagrams in the accompanying drawings illustrate the architecture, functions and operations of possible implementations of systems, methods and computer program products according to a plurality of embodiments of the present disclosure. Each block in the flow chart or the block diagram may represent a module, a program segment, or a part of instructions. The module, the program segment or the part of instructions contains one or more executable instructions for implementing specified logical functions. In some alternative implementations, the functions noted in the blocks may also occur in an order different from those noted in the accompanying drawings. For example, two consecutive blocks may actually be executed in substantially parallel, and sometimes may be executed in a reverse order, which depends on the functions involved. It should also be noted that, each block in the block diagram and/or the flow chart, and the combination of blocks in the block diagram and/or the flow chart, may be implemented with a dedicated hardware-based system for performing specified functions or actions, or may be implemented with a combination of dedicated hardware and computer instructions.

Various embodiments of the present disclosure have been described above, and the above description is exemplary, not exhaustive, and is not limited to the disclosed embodiments. A plurality of modifications and variations may be apparent to the skilled in the art without departing from the scope of the illustrated embodiments. Terms used herein are selected to best explain the principles of various embodiments, practical applications or technical improvements to technologies in the market, or to enable other skilled in the art to understand various embodiments disclosed herein

## Claims

1. A method (200) for controlling a simulation vehicle (130), the method comprising:
determining (202), by a simulation device (110), a first region corresponding to a first simulation position where the simulation vehicle (130) is located at a first time point;
obtaining (204), by the simulation device (110), first environment information about the first region and second environment information about a second region adjacent to the first region, wherein the first environment information includes a first obstacle information and first road network information related to the first region, and the second environment information includes a second obstacle information and second road network information related to the second region;
sending (206), by the simulation device (110), the first environment information and the second environment information to a control device (120) of the simulation vehicle (130);
generating (304), by the control device (120), a control signal for the simulation vehicle (130) based on the first environment information and the second environment information, wherein the control signal is configured to control an action performed by the simulation vehicle (130);
receiving (208), by the simulation device (110), the control signal for the simulation vehicle (130) from the control device (120);
determining (210), by the simulation device (110), a first action performed by the simulation vehicle (130) at a second time point after the first time point based on the control signal;
determining whether the first action meets a predetermined evaluation criterion related to vehicle driving.

2. The method of claim 1, wherein the first obstacle information comprises perceptual information about an obstacle in the first region, the perceptual information indicating at least one of a position, a shape, a category, a speed and an orientation of the obstacle.

3. The method of any one of claims 1 or 2, wherein determining (202) the first region comprises:
obtaining predetermined correspondence information between simulation positions and regions, wherein a simulation position range corresponds to a region; and
determining the first region corresponding to the first simulation position based on the predetermined correspondence information.

4. The method of any one of claims 1 to 3, wherein determining (210) the first action comprises:
determining the first action based on the control signal and a predetermined vehicle dynamic model, the first action comprising at least one of braking, turning, moving on, moving back, accelerating and decelerating.

5. The method of any one of claims 1 to 4, further comprising:
obtaining a simulation model corresponding to an obstacle in the first region; and
determining a second action performed by the obstacle at the second time point based on the simulation model, the first environment information and the second environment information.

6. The method of any one of claims 1 to 5, further comprising:
storing scene information associated with the second time point and the simulation vehicle (130) in response to determining that the first action does not meet the predetermined evaluation criterion.

7. The method of any one of claims 1 to 6, further comprising:
storing scene information associated with the second time point and the simulation vehicle (130) in response to receiving a scene information storing request from the control device.

8. The method of claim 6 or 7, wherein storing the scene information comprises:
storing at least one of event information, environment information, communication information and log information associated with the second time point and the simulation vehicle (130).

9. The method of any one of claims 1 to 8, further comprising:
restarting the simulation vehicle (130) in response to determining that communication between the simulation device (110) and the control device (120) is abnormal.

10. The method of any one of claims 1 to 9, further comprising:
converting a loaded map into a topological graph; and
dividing the topological graph into a plurality of regions.

## Patentansprüche

1. Ein Verfahren (200) zum Steuern eines Simulationsfahrzeugs (130), wobei das Verfahren folgende Schritte aufweist:
Bestimmen (202), durch eine Simulationsvorrichtung (110), einer ersten Region, die einer ersten Simulationsposition entspricht, wo sich das Simulationsfahrzeug (130) zu einem ersten Zeitpunkt befindet;
Erhalten (204), durch die Simulationsvorrichtung (110), erster Umgebungsinformationen über die erste Region und zweiter Umgebungsinformationen über eine zweite Region benachbart zu der ersten Region, wobei die ersten Umgebungsinformationen erste Hindernisinformationen und erste Straßennetzinformationen umfassen, die sich auf die erste Region beziehen, und die zweiten Umgebungsinformationen zweite Hindernisinformationen und zweite Straßennetzinformationen umfassen, die sich auf die zweite Region beziehen;
Senden (206), durch die Simulationsvorrichtung (110), der ersten Umgebungsinformationen und der zweiten Umgebungsinformationen an eine Steuervorrichtung (120) des Simulationsfahrzeugs (130);
Erzeugen (304), durch die Steuervorrichtung (120), eines Steuersignals für das Simulationsfahrzeug (130) basierend auf den ersten Umgebungsinformationen und den zweiten Umgebungsinformationen, wobei das Steuersignal konfiguriert ist, eine Aktion zu steuern, die durch das Simulationsfahrzeug (130) durchgeführt wird;
Empfangen (208), durch die Simulationsvorrichtung (110), des Steuersignals für das Simulationsfahrzeug (130) von der Steuervorrichtung (120);
Bestimmen (210), durch die Simulationsvorrichtung (110), einer ersten Aktion, die durch das Simulationsfahrzeug (130) zu einem zweiten Zeitpunkt nach dem ersten Zeitpunkt basierend auf dem Steuersignal durchgeführt wird;
Bestimmen, ob die erste Aktion ein vorbestimmtes Auswertungskriterium erfüllt, das sich auf ein Fahren eines Fahrzeugs bezieht.

2. Das Verfahren gemäß Anspruch 1, bei dem die ersten Hindernisinformationen Wahrnehmungsinformationen über ein Hindernis in einer ersten Region aufweisen, wobei die Wahrnehmungsinformationen zumindest eines einer Position, einer Form, einer Kategorie, einer Geschwindigkeit und einer Ausrichtung des Hindernisses anzeigen.

3. Das Verfahren gemäß einem der Ansprüche 1 oder 2, bei dem das Bestimmen (202) der ersten Region folgende Schritte aufweist:
Erhalten vorbestimmter Entsprechungsinformationen zwischen Simulationspositionen und Regionen, wobei ein Simulationspositionsbereich einer Region entspricht; und
Bestimmen der ersten Region, die der ersten Simulationsposition entspricht, basierend auf den vorbestimmten Entsprechungsinformationen.

4. Das Verfahren gemäß einem der Ansprüche 1 bis 3, bei dem das Bestimmen (210) der ersten Aktion folgenden Schritt aufweist:
Bestimmen der ersten Aktion basierend auf dem Steuersignal und einem vorbestimmten Fahrzeugdynamikmodell, wobei die erste Aktion zumindest eines von Bremsen, Abbiegen, Weiterfahren, Zurückfahren, Beschleunigen und Verlangsamen aufweist.

5. Das Verfahren gemäß einem der Ansprüche 1 bis 4, das ferner folgende Schritte aufweist:
Erhalten eines Simulationsmodells, das einem Hindernis in der ersten Region entspricht; und
Bestimmen einer zweiten Aktion, die durch das Hindernis an dem zweiten Zeitpunkt durchgeführt wird, basierend auf dem Simulationsmodell, den ersten Umgebungsinformationen und den zweiten Umgebungsinformationen.

6. Das Verfahren gemäß einem der Ansprüche 1 bis 5, das ferner folgenden Schritt aufweist:
Speichern von Szeneninformationen, die dem zweiten Zeitpunkt und dem Simulationsfahrzeug (130) zugeordnet sind, ansprechend auf ein Bestimmen, dass die erste Aktion das vorbestimmte Auswertungskriterium nicht erfüllt.

7. Das Verfahren gemäß einem der Ansprüche 1 bis 6, das ferner folgenden Schritt aufweist:
Speichern von Szeneninformationen, die dem zweiten Zeitpunkt und dem Simulationsfahrzeug (130) zugeordnet sind, ansprechend auf ein Empfangen einer Szeneninformationsspeicheranforderung von der Steuervorrichtung.

8. Das Verfahren gemäß Anspruch 6 oder 7, bei dem das Speichern der Szeneninformationen folgenden Schritt aufweist:
Speichern zumindest eines von Ereignisinformationen, Umgebungsinformationen, Kommunikationsinformationen und Protokollinformationen, die dem zweiten Zeitpunkt und dem Simulationsfahrzeug (130) zugeordnet sind.

9. Das Verfahren gemäß einem der Ansprüche 1 bis 8, das ferner folgenden Schritt aufweist:
Neustarten des Simulationsfahrzeugs (130) ansprechend auf ein Bestimmen, dass eine Kommunikation zwischen der Simulationsvorrichtung (110) und der Steuervorrichtung (120) anormal ist.

10. Das Verfahren gemäß einem der Ansprüche 1 bis 9, das ferner folgende Schritte aufweist:
Umwandeln einer geladenen Karte in einen topologischen Graphen; und
Unterteilen des topologischen Graphen in eine Mehrzahl von Regionen.

## Revendications

1. Procédé (200) de commande d'un véhicule de simulation (130), le procédé comprenant le fait de:
déterminer (202), par un dispositif de simulation (110), une première région correspondant à une première position de simulation où le véhicule de simulation (130) est situé à un premier moment;
obtenir (204), par le dispositif de simulation (110), des premières informations d'environnement sur la première région et des deuxièmes informations d'environnement sur une deuxième région adjacente à la première région, où les premières informations d'environnement comportent des premières informations d'obstacle et des premières informations de réseau routier relatives à la première région, et les deuxièmes informations d'environnement comportent des deuxièmes informations d'obstacle et des deuxièmes informations de réseau routier relatives à la deuxième région;
envoyer (206), par le dispositif de simulation (110), les premières informations d'environnement et les deuxièmes informations d'environnement à un dispositif de commande (120) du véhicule de simulation (130);
générer (304), par le dispositif de commande (120), un signal de commande pour le véhicule de simulation (130) sur base des premières informations d'environnement et des deuxièmes informations d'environnement, où le signal de commande est configuré pour commander une action effectuée par le véhicule de simulation (130);
recevoir (208), par le dispositif de simulation (110), le signal de commande pour le véhicule de simulation (130) du dispositif de commande (120);
déterminer (210), par le dispositif de simulation (110), une première action effectuée par le véhicule de simulation (130) à un deuxième moment après le premier moment sur base du signal de commande;
déterminer si la première action remplit un critère d'évaluation prédéterminé relatif à la conduite du véhicule.

2. Procédé selon la revendication 1, dans lequel les premières informations d'obstacle comprennent des informations perceptuelles sur un obstacle dans la première région, les informations perceptuelles indiquant au moins l'une parmi une position, une forme, une catégorie, une vitesse et une orientation de l'obstacle.

3. Procédé selon l'une quelconque des revendications 1 ou 2, dans lequel la détermination (202) de la première région comprend le fait de:
obtenir des informations de correspondance prédéterminées entre les positions de simulation et les régions, où une plage de positions de simulation correspond à une région; et
déterminer la première région correspondant à la première position de simulation sur base des informations de correspondance prédéterminées.

4. Procédé selon l'une quelconque des revendications 1 à 3, dans lequel la détermination (210) de la première action comprend le fait de:
déterminer la première action sur base du signal de commande et d'un modèle dynamique de véhicule prédéterminé, la première action comprenant au moins l'un parmi le fait de freiner, tourner, avancer, reculer, accélérer et décélérer.

5. Procédé selon l'une quelconque des revendications 1 à 4, comprenant par ailleurs le fait de:
obtenir un modèle de simulation correspondant à un obstacle dans la première région; et
déterminer une deuxième action effectuée par l'obstacle au deuxième moment sur base du modèle de simulation, des premières informations d'environnement et des deuxièmes informations d'environnement.

6. Procédé selon l'une quelconque des revendications 1 à 5, comprenant par ailleurs le fait de:
mémoriser les informations de scène associées au deuxième moment et au véhicule de simulation (130) en réponse à la détermination du fait que la première action ne remplit pas le critère d'évaluation prédéterminé.

7. Procédé selon l'une quelconque des revendications 1 à 6, comprenant par ailleurs le fait de:
mémoriser les informations de scène associées au deuxième moment et au véhicule de simulation (130) en réponse à la réception d'une demande de mémoriser les informations de scène provenant du dispositif de commande.

8. Procédé selon la revendication 6 ou 7, dans lequel la mémorisation des informations de scène comprend le fait de:
mémoriser au moins les unes parmi les informations d'événement, les informations d'environnement, les informations de communication et les informations de connexion associées au deuxième moment et au véhicule de simulation (130).

9. Procédé selon l'une quelconque des revendications 1 à 8, comprenant par ailleurs le fait de:
redémarrer le véhicule de simulation (130) en réponse à la détermination du fait que la communication entre le dispositif de simulation (110) et le dispositif de commande (120) est anormale.

10. Procédé selon l'une quelconque des revendications 1 à 9, comprenant par ailleurs le fait de:
convertir une carte chargée en un graphique topologique; et
diviser le graphique topologique en une pluralité de régions.
